# EUROPÄISCHE PATENTSCHRIFT

(11) **EP 2 586 122 B1**
(45) Veröffentlichungstag und Bekanntmachung des Hinweises auf die Patenterteilung: **19.03.2014**
(21) Anmeldenummer: 11729079.1
(22) Anmeldetag: 15.06.2011
(51) Int. Cl.: H02M 3/337, H03B 5/32, H02N 2/00, H03J 5/24, H02M 7/48

(54) **VERFAHREN ZUM BETREIBEN EINER STELLEINRICHTUNG EINES RESONANZKREISES SOWIE STELLEINRICHTUNG**
METHOD FOR OPERATING CONTROL EQUIPMENT OF A RESONANCE CIRCUIT AND CONTROL EQUIPMENT
PROCÉDÉ POUR FAIRE FONCTIONNER UN DISPOSITIF DE COMMANDE D'UN CIRCUIT RÉSONNANT ET DISPOSITIF DE COMMANDE

(30) Priorität: 22.06.2010 DE 102010030328
(43) Veröffentlichungstag der Anmeldung: 01.05.2013
(73) Patentinhaber: Robert Bosch GmbH, 70442 Stuttgart (DE)
(72) Erfinder: KUEHNER, Jochen, 71522 Backnang (DE)
(86) Internationale Anmeldenummer: PCT/EP2011/059967
(87) Internationale Veröffentlichungsnummer: WO 2011/160993

(56) Entgegenhaltungen:
- EP-A2- 1 124 317
- DE-A1-102005 010 927
- US-A- 5 642 065
- US-A1- 2004 066 178
- US-A1- 2006 125 454
- US-A1- 2010 118 565

## Beschreibung

### Stand der Technik

Die Erfindung betrifft ein Verfahren zum Betreiben einer Stelleinrichtung eines Resonanzkreises, wobei die Stelleinrichtung über mindestens zwei in Reihe geschaltete, insbesondere jeweils eine parallel geschaltete Freilaufdiode aufweisende Schaltelemente verfügt, zwischen welchen ein Anschluss des Resonanzkreises angeschlossen ist. Die Erfindung betrifft weiterhin eine Stelleinrichtung eines Resonanzkreises.

Verfahren der eingangs genannten Art sind aus dem Stand der Technik bekannt, z.B. aus US 2006/0125454 und US 5 642 065. Der Resonanzkreis ist beispielsweise ein elektrischer beziehungsweise ein elektro-mechanischer Resonanzkreis. Der Resonanzkreis kann auch als Schwingkreis bezeichnet werden. Er besteht üblicherweise aus mindestens einem kapazitiven Element (Kondensator) sowie mindestens einem induktiven Element (Spule). Der Schwingkreis ist somit eine resonanzfähige elektrische Schaltung, welche elektrische Schwingungen ausführen kann. Bei einem LC-Schwingkreis aus Spule und Kondensator wird Energie zwischen dem magnetischen Feld der Spule und dem elektrischen Feld des Kondensators periodisch ausgetauscht, wodurch abwechselnd hohe Stromstärke oder hohe Spannung vorliegen.

Dem Resonanzkreis ist die Stelleinrichtung zugeordnet, welche dem Erregen des Resonanzkreises, bevorzugt bei dessen Resonanzfrequenz, dient. Dabei weist die Stelleinrichtung die mindestens zwei Schaltelemente auf, welche bevorzugt in Reihe geschaltet sind. Vorteilhafterweise ist jedem der Schaltelemente eine Freilaufdiode parallel geschaltet. Der Anschluss des Resonanzkreises ist zwischen den in Reihe geschalteten Schaltelementen vorgesehen. Durch die Schaltelemente, welche auch als Stellglieder bezeichnet werden können, wird dem Resonanzkreis eine Frequenz vorgegeben. Diese stimmt vorzugsweise mit der Resonanzfrequenz des Resonanzkreises überein. Um die Ansteuerungsfrequenz, mit welcher die Schaltelemente zum Ansteuern des Resonanzkreises betätigt werden, einzustellen, werden üblicherweise eine Drosselspannung und ein Drosselstrom gemessen. Die Drosselspannung und der Drosselstrom entsprechen dabei der Spannung, welche über das induktive Element abfällt, und dem Strom, welcher das induktive Element durchläuft. Zumindest ist es jedoch vorgesehen, den Drosselstrom zu bestimmen, um die Resonanzregelung des Resonanzkreises mittels der Stelleinrichtung durchzuführen.

Dabei ist es jedoch notwendig, eine Sensorik vorzusehen, um den Drosselstrom und eventuell zusätzlich die Drosselspannung zu bestimmen. Zusätzlich muss eine Einrichtung vorgesehen sein, um die mittels der Sensorik erfassten Signale auszuwerten und basierend auf dieser Auswertung die Resonanzregelung durchzuführen. Bei der Aufbereitung der Signale kommt häufig die so genannte Differenzphasenbestimmung zum Einsatz. Die Bestimmung der Drosselspannung beziehungsweise des Drosselstroms ist jedoch aufwändig und die dazu notwendige Sensorik kostenaufwändig.

### Offenbarung der Erfindung

Demgegenüber weist das Verfahren zum Betreiben der Stelleinrichtung des Resonanzkreises mit den in Anspruch 1 genannten Merkmalen den Vorteil auf, dass die Stelleinrichtung ohne die vorstehend beschriebene Sensorik zur Bestimmung der Drosselspannung beziehungsweise des Drosselstroms betreibbar ist. Dies wird erfindungsgemäß erreicht, indem die Schaltelemente in Abhängigkeit einer an dem Anschluss abgegriffenen Spannung angesteuert werden. Es ist demnach weder eine Sensorik zur Bestimmung der Drosselspannung noch eine Sensorik zur Bestimmung des Drosselstroms notwendig. Vielmehr soll lediglich die Spannung zwischen den Schaltelementen beziehungsweise an dem Anschluss abgegriffen werden. Basierend auf dieser Spannung können die Schaltelemente zuverlässig angesteuert werden. Die Spannung ist dabei ein Maß für den momentanen fließenden Drosselstrom, insbesondere wenn alle Schaltelemente geöffnet sind, ist jedoch deutlich einfacher zu bestimmen als dieser. Die zwei Schaltelemente bilden eine Halbbrücke mit einem schaltungstechnisch zwischen sich angeordneten Mittelabgriff, an welchem der Anschluss des Resonanzkreises angeschlossen ist. Die Schaltelemente können beispielsweise leistungselektronische Stellglieder sein. Die an dem Anschluss abgegriffene Spannung wird beispielsweise in Bezug auf einen weiteren Anschluss des Resonanzkreises bestimmt. Die Spannungsbestimmung kann demnach zwischen den beiden Anschlüssen des Resonanzkreises erfolgen, bevorzugt parallel zu einem der Schaltelemente beziehungsweise der dazugehörigen Freilaufdiode.

Eine Weiterbildung der Erfindung sieht vor, dass die Schaltelemente zum Erregen des Resonanzkreises periodisch geöffnet und geschlossen werden, wobei die Spannung nur dann an dem Anschluss abgegriffen wird, wenn die Schaltelemente geöffnet sind. Zum Betreiben der Stelleinrichtung beziehungsweise zum Erregen des Resonanzkreises werden die Schaltelemente in an sich bekannter Weise periodisch geöffnet und geschlossen. Weil die Schaltelemente in Reihe geschaltet sind, dürfen sie nicht gleichzeitig geschlossen, also stromleitend sein, um einen Kurzschluss der Stelleinrichtung zu vermeiden. Weil üblicherweise in der Praxis Einschalt- und/oder Ausschaltverzögerungen der Schaltelemente auftreten, werden diese mit Verriegelungszeiten beziehungsweise Totzeiten angesteuert. Durch diese Zeiten ergibt sich ein Zeitraum, in welchem keines der Schaltelemente geschlossen ist beziehungsweise Strom leitet. In diesem Zeitraum wird der Strom durch zumindest eine der Freilaufdioden geführt. Es ist nun vorgesehen, die Spannung an dem Anschluss abzugreifen, während die Schaltelemente, beziehungsweise alle Schaltelemente, geöffnet sind. Es wird somit die Spannung des Mittelabgriffs der aus den Schaltelementen gebildeten Halbbrücke abgegriffen. Aus dieser Spannung kann bestimmt werden, ob sich die momentane Ansteuerungsfrequenz, mit welcher die Schaltelemente der Stelleinrichtung angesteuert werden, oberhalb oder unterhalb der Resonanzfrequenz des Resonanzkreises befindet. Mit dieser Information kann die Ansteuerungsfrequenz steuernd und/oder regelnd nachgeführt werden, so dass der Resonanzkreis stets bei seiner Resonanzfrequenz betrieben wird.

Eine Weiterbildung der Erfindung sieht vor, dass die abgegriffene Spannung zum Wandeln in ein Digitalsignal einem Komparator, insbesondere einem Schmitt-Trigger, zugeführt wird. Wie bereits vorstehend beschrieben, fließt in dem Zeitraum, in welchem die Schaltelemente geöffnet sind, der Strom über eine der Freilaufdioden. Bei positivem Strom fließt er dabei durch die eine der Freilaufdioden und bei negativem Strom durch die andere der Freilaufdioden. Daraus folgt, dass die an dem Anschluss abgegriffene Spannung beispielsweise bei positivem Strom zu null wird und bei negativem Strom einer Versorgungsspannung entspricht. Die Differenz zwischen der abgegriffenen Spannung bei positivem Strom und der abgegriffenen Spannung bei negativem Strom entspricht also dem Betrag der Versorgungsspannung. Die abgegriffene Spannung steht in Abhängigkeit von der Stromrichtung. Um aus der Spannung das Digitalsignal zu erzeugen, wird sie dem Komparator zugeführt. Der Komparator vergleicht dabei die abgegriffene Spannung vorzugsweise mit einer Spannung, welche größer als die zu erwartende Minimalspannung und kleiner als die zu erwartende Maximalspannung ist. Auf diese Weise können Fehler, welche beispielsweise durch die Durchlassspannung der Freilaufdioden verursacht werden, herausgefiltert werden. Der Komparator ist vorzugsweise ein Schmitt-Trigger. Wenn die Schaltelemente geöffnet sind, so zeigt das Digitalsignal folglich die Polarität des Drosselstroms an. Auf Grundlage dieser Polarität können nun die Schaltelemente derart angesteuert werden, dass der Resonanzkreis bei seiner Resonanzfrequenz betrieben wird.

Eine Weiterbildung der Erfindung sieht vor, dass das Digitalsignal als Eingangssignal für einen Flip-Flop und/oder einen Zähler verwendet wird. Mittels des Flip-Flops kann das Digitalsignal zeitstabil gemacht werden. Der Flip-Flop wird zu diesem Zweck mit einer bestimmten Abtastfrequenz angesteuert. Zusätzlich oder alternativ ist der Zähler vorgesehen. Mit dem Zähler kann aus dem Digitalsignal eine neue Ansteuerungsfrequenz bestimmt werden, mit welcher die Stelleinrichtung anstelle der bisherigen Ansteuerungsfrequenz betrieben werden muss beziehungsweise die Schaltelemente angesteuert werden müssen, um den Resonanzkreis bei seiner Resonanzfrequenz zu betreiben oder zumindest näher an der Resonanzfrequenz zu liegen als mit der momentan verwendeten Ansteuerungsfrequenz. Mit dem Zähler wird somit die neue Ansteuerungsfrequenz bestimmt, welche nachfolgend anstelle der bisherigen Ansteuerungsfrequenz zum Betreiben der Stelleinrichtung verwendet wird. Besonders bevorzugt wird das Digitalsignal dem Flip-Flop zugeführt und der Zähler an einen Ausgang des Flip-Flops angeschlossen. Auf diese Weise kann ein äußerst robuster Betrieb der Stelleinrichtung erzielt werden.

Eine Weiterbildung der Erfindung sieht vor, dass eine Steuerung der Stelleinrichtung die Schaltelemente mit einer, insbesondere mittels des Zählers, bestimmten Frequenz ansteuert. Die Steuerung ist dazu vorgesehen, die Schaltelemente so anzusteuern, dass sie entweder ihren geöffneten oder ihren geschlossenen Zustand annehmen. Das Ansteuern erfolgt dabei derart, dass die Schaltelemente abwechselnd beziehungsweise periodisch geöffnet und geschlossen werden, jedoch nie gleichzeitig geschlossen sind, um den vorstehend beschriebenen Kurzschluss in der Stelleinrichtung zu vermeiden. Die Ansteuerung der Schaltelemente erfolgt dabei mit der bestimmten (Ansteuerungs-) Frequenz. Die bestimmte Frequenz wird vorzugsweise mittels des Zählers ermittelt.

Eine Weiterbildung der Erfindung sieht vor, dass von der Steuerung dem Flip-Flop und/oder dem Zähler ein Taktsignal zugeführt wird. Üblicherweise ist dabei das Taktsignal des Flip-Flops von dem Taktsignal des Zählers unterschiedlich. Die Steuerung übermittelt dem Flip-Flop vorzugsweise das Taktsignal, wenn die Spannung an dem Anschluss abgegriffen werden soll, also die Schaltelemente geöffnet sind. Dagegen weist das dem Zähler zugeführten Taktsignal vorzugsweise eine konstante Frequenz auf.

Eine Weiterbildung der Erfindung sieht vor, dass das Abgreifen der Spannung durch das dem Flip-Flop zugeführte Taktsignal bewirkt wird. Wie vorstehend beschrieben, wird dem Flip-Flop von der Steuerung das Taktsignal zugeführt, wenn die Spannung an dem Anschluss abgegriffen werden soll. Dies ist üblicherweise der Fall, wenn die Schaltelemente geöffnet sind.

Eine Weiterbildung der Erfindung sieht vor, dass der Resonanzkreis zur berührungslosen Energieübertragung oder zum Ansteuern eines Piezoschwingers verwendet wird. Auf diese Weise lassen sich besonders kostengünstige Einrichtungen zum berührungslosen Energieübertragung beziehungsweise zum Ansteuern des Piezoschwingers realisieren.

Die Erfindung betrifft weiterhin eine Stelleinrichtung eines Resonanzkreises, insbesondere zur Durchführung des vorstehend beschriebenen Verfahrens, mit mindestens zwei in Reihe geschalteten, insbesondere jeweils eine parallel geschaltete Freilaufdiode aufweisenden Schaltelementen, zwischen welchen ein Anschluss des Resonanzkreises angeschlossen ist. Dabei ist vorgesehen, dass die Stelleinrichtung dazu ausgebildet ist, die Schaltelemente in Abhängigkeit einer an dem Anschluss abgegriffenen Spannung anzusteuern.

Zusätzlich ist die Erfindung gleichsam auf eine Einrichtung zum berührungslosen Energieübertragen und eine Einrichtung zum Ansteuern eines Piezoschwingers gerichtet. Diese weisen jeweils die vorstehend beschriebene Stelleinrichtung auf und/oder sind zur Durchführung des vorstehend beschriebenen Verfahrens vorgesehen.

Die Erfindung wird nachfolgend anhand der in der Zeichnung dargestellten Ausführungsbeispiele näher erläutert, ohne dass eine Beschränkung der Erfindung erfolgt. Dabei zeigen:
Figur 1 ein Schaltbild einer Stelleinrichtung und eines Resonanzkreises, mit welchen ein Verfahren zum Betreiben der Stelleinrichtung umsetzbar ist,
Figur 2 ein Schaltbild, wobei der Resonanzkreis zur berührungslosen Energieübertragung verwendet wird,
Figur 3 der Resonanzkreis für die Anwendung zur Ansteuerung eines Piezoschwingers,
Figur 4 ein Diagramm, in welchem ein Drosselstrom und eine abgegriffene Spannung über der Zeit dargestellt werden, wenn der Resonanzkreis bei seiner Resonanzfrequenz betrieben wird,
Figur 5 das aus der Figur 4 bekannte Diagramm, bei einem Betrieb des Resonanzkreises mit einer Ansteuerungsfrequenz, welche größer ist als die Resonanzfrequenz, und
Figur 6 das aus der Figur 4 bekannte Diagramm, bei einem Betrieb des Resonanzkreises bei einer Ansteuerungsfrequenz, welche kleiner ist als die Resonanzfrequenz.

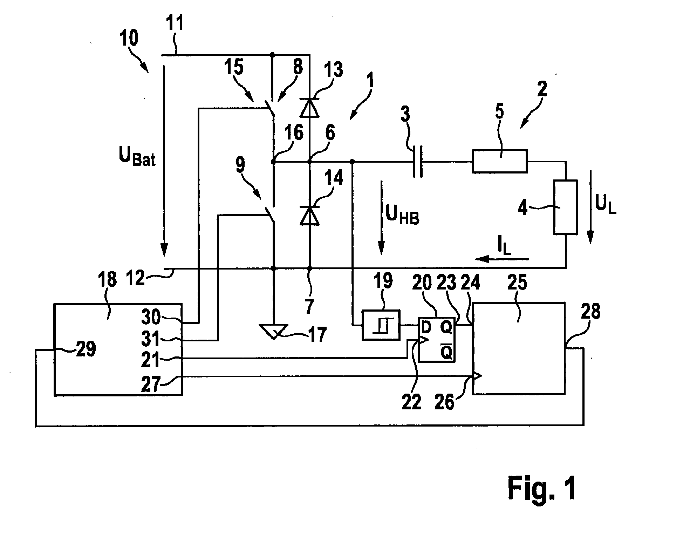

Die Figur 1 zeigt ein Schaltbild, in welchem eine Stelleinrichtung 1 und ein Resonanzkreis 2 dargestellt sind. Die Stelleinrichtung 1 dient dabei dem Ansteuern beziehungsweise einem Erregen des Resonanzkreises 2.

Der Resonanzkreis 2 weist in dem hier dargestellten Ausführungsbeispiel einen Kondensator 3, eine Spule 4 und einen (optionalen) Widerstand 5 auf. Der Kondensator 3, die Spule 4 und der Widerstand 5 sind dabei in Reihe geschaltet. Der Resonanzkreis 2 weist einen ersten Anschluss 6 und einen zweiten Anschluss 7 auf. In dem vorliegenden Ausführungsbeispiel sind beide Anschlüsse 6 und 7 an die Stelleinrichtung 1 angeschlossen.

Die Stelleinrichtung 1 weist zwei Schaltelemente 8 und 9 auf, welche miteinander in Reihe an eine Energieversorgungseinrichtung 10 (welche hier nicht näher dargestellt ist) angeschlossen sind. Die Energieversorgungseinrichtung 10 stellt zwischen Polen 11 und 12 eine Versorgungsspannung U_{Bat} bereit. Die Reihenschaltung der beiden Schaltelemente 8 und 9 ist dabei zwischen den zwei Polen 11 und 12 der Energieversorgungseinrichtung 10 vorgesehen. Das Schaltelement 8 ist dem Pol 11 und das Schaltelement 9 dem Pol 12 zugeordnet beziehungsweise jeweils unmittelbar an diesen angeschlossen. Die Schaltelemente 8 und 9 weisen jeweils eine parallel geschaltete Freilaufdiode 13 beziehungsweise 14 auf. Die Schaltelemente 8 und 9 bilden insoweit eine Halbbrücke 15 mit einem Mittelabgriff 16, der zwischen den Schaltelementen 8 und 9 vorliegt. Der erste Anschluss 6 des Resonanzkreises 2 ist nun an diesen Mittelabgriff 16 angeschlossen, während der zweite Anschluss 7 an den Pol 12 der Energieversorgungseinrichtung 10 angeschlossen ist. Der Resonanzkreis 2 liegt demnach parallel zu dem Schaltelement 9 beziehungsweise der Freilaufdiode 14 vor. Der Pol 11 der Energieversorgungseinrichtung 10 weist beispielsweise ein positives Potenzial auf, während der Pol 12 einer Masse entspricht, wie durch das Symbol 17 angedeutet ist. Die Schaltelemente 8 und 9 sind beispielsweise leistungselektronische Stellglieder.

Die Schaltelemente 8 und 9 werden mittels einer Steuerung 18 der Stelleinrichtung 1 mit einer Ansteuerungsfrequenz jeweils zum Öffnen oder Schließen angesteuert. Die Schaltelemente 8 und 9 werden also periodisch geöffnet und geschlossen. Auf diese Weise findet eine Erregung des Resonanzkreises 2 statt. Durch die Schaltelemente 8 und 9 wird dem Resonanzkreis 2 die Ansteuerungsfrequenz vorgegeben. Um den Resonanzkreis 2 effizient zu betreiben, muss diese Ansteuerungsfrequenz zumindest näherungsweise mit der Resonanzfrequenz des Resonanzkreises 2 übereinstimmen. Die Resonanzfrequenz hängt dabei von verschiedenen Eigenschaften des Resonanzkreises 2 ab, beispielsweise der Kapazität des Kondensators 3 und der Induktivität der Spule 4. Zur Regelung der Ansteuerungsfrequenz der Schaltelemente 8 und 9 ist es aus dem Stand der Technik bekannt, die Drosselspannung U_{L} und den Drosselstrom I_{L} zu messen und anhand der Phasenverschiebung zwischen Drosselspannung U_{L} und Drosselstrom I_{L} die Regelung vorzunehmen.

Erfindungsgemäß ist es vorgesehen, an dem Anschluss 6 beziehungsweise dem Mittelabgriff 16 eine Spannung U_{HB} abzugreifen und die Schaltelemente 8 und 9 in Abhängigkeit dieser abgegriffenen Spannung U_{HB} anzusteuern. Es entfällt somit die üblicherweise verwendete Sensorik zur Bestimmung der Drosselspannung U_{L} und des Drosselstroms I_{L}. Zu diesem Zweck ist der erste Anschluss 6 beziehungsweise der Mittelabgriff 16 an einen Komparator 19 angeschlossen, welcher hier als Schmitt-Trigger ausgeführt ist. Die abgegriffene Spannung U_{HB} dient somit als Eingangssignal für den Komparator 19. Ein Ausgangssignal des Komparators 19 wird einem Flip-Flop 20 zugeführt. Zusätzlich wird dem Flip-Flop 20 ein Taktsignal von der Steuerung 18 zugeführt. Dazu ist ein Taktsignalausgang 21 der Steuerung 18 mit einem Taktsignaleingang 22 des Flip-Flops 20 verbunden. Ein Ausgang 23 des Flip-Flops 20 ist mit einem Eingang 24 eines Zählers 25 verbunden. Dem Zähler 25 wird zusätzlich an einem Taktsignaleingang 26 ein Taktsignal zugeführt, welches die Steuerung 18 an einem Taktsignalausgang 27 ausgibt. Der Zähler 25 verfügt über einen Frequenzsignalausgang 28, welcher mit einem Frequenzsignaleingang 29 der Steuerung 18 verbunden ist. Die Steuerung 18 verfügt weiterhin über einen ersten Steuerausgang 30 und einen zweiten Steuerausgang 31, wobei an den ersten Steuerausgang 30 das Schaltelement 8 und an den zweiten Steuerausgang 31 das Schaltelement 9 angeschlossen ist. Über die Steuerausgänge 30 und 31 bewirkt die Steuerung 18 das Öffnen oder Schließen der Schaltelemente 8 und 9.

Für die Stelleinrichtung 1 und den Resonanzkreis 2 ergibt sich folgende Funktion: Mittels der Steuerung 18 werden die Schaltelemente 8 und 9 periodisch geöffnet und geschlossen, wobei dies mit einer Ansteuerungsfrequenz erfolgt. Damit wird in an und für sich bekannter Weise eine Schwingung des Resonanzkreises 2 angeregt. Um einen Kurzschluss zwischen den Polen 11 und 12 trotz der zur Durchführung eines Schaltvorgangs der Schaltelemente 8 und 9 benötigten Zeit zu vermeiden, sind Verriegelungszeiten beziehungsweise Totzeiten vorgesehen, in welchen die Schaltelemente 8 und 9 gleichzeitig geöffnet sind. Die Ansteuerung der Schaltelemente 8 und 9 erfolgt demnach derart, dass beispielsweise zunächst das Schaltelement 8 geschlossen ist. Soll nun das Schaltelement 8 geöffnet und das Schaltelement 9 geschlossen werden, so wird zunächst das Schaltelement 8 geöffnet und erst nach einer vorbestimmten Zeitspanne, der Verriegelungszeit beziehungsweise Totzeit, das Schaltelement 9 zum Schließen durch die Steuerung 18 angesteuert. Somit kann nie der Fall auftreten, dass die Schaltelemente 8 und 9 gleichzeitig geschlossen sind. Ein Kurzschluss zwischen den Polen 11 und 12 der Energieversorgungseinrichtung 10 ist somit effektiv verhindert.

Während die Schaltelemente 8 und 9 geöffnet sind, wird der Strom durch die Freilaufdiode 13 beziehungsweise 14 geführt. Ist der momentan in dem Resonanzkreis 2 vorliegende Strom positiv, so fliest er durch die Freilaufdiode 14. Ist er negativ, so durchströmt er die Freilaufdiode 13. Daraus folgt, dass die abgegriffene Spannung U_{HB} unter Vernachlässigung der Dioden-Durchlassspannung bei positivem Strom zu Null wird und bei negativem Strom der Versorgungsspannung U_{Bat} entspricht. Der Spannungshub entspricht also dem Betrag der Versorgungsspannung U_{Bat}. An dem ersten Anschluss 6 beziehungsweise dem Mittelabgriff 16 kann demnach die Spannung U_{HB} abgegriffen werden, welche in Abhängigkeit von der Stromrichtung des Stroms entweder U_{Bat} oder null ist.

Die Spannung U_{HB} wird mithilfe des Komparators 19 in ein Digitalsignal umgewandelt. Dabei wird sie von dem Komparator 19 mit einer vorgegebenen, üblicherweise konstanten Referenzspannung verglichen, welche vorzugsweise größer als null, jedoch kleiner als die Versorgungsspannung U_{Bat} ist. Das Digitalsignal zeigt demnach - wenn die Schaltelemente 8 und 9 geöffnet sind - die Polarität des Drosselstroms I_{L} an. Das Abgreifen der Spannung U_{HB} erfolgt, wenn dem dem Komparator 19 nachgeschalteten Flip-Flop 20 über den Taktsignaleingang 22 ein Taktsignal zugeführt wird. Das Zuführen des Taktsignals erfolgt dabei durch die Steuerung 18, wenn die Schaltelemente 8 und 9 beide geöffnet sind. An seinem Ausgang 23 stellt der Flip-Flop 20 demnach ein zeitstabiles Digitalsignal zur Verfügung, welches der zuletzt abgegriffenen Spannung U_{HB} entspricht. Dieses Signal wird dem Eingang 24 des Zählers 27 zugeführt. Gleichzeitig wird der Zähler 25, bevorzugt von der Steuerung 18, mit einem weiteren Taktsignal beaufschlagt, welches vorzugweise eine konstanten Frequenz aufweist. Ist das an dem Eingang 24 anliegende Digitalsignal gesetzt, die abgegriffene Spannung U_{HB} also positiv beziehungsweise der Drosselstrom I_{L} negativ, so zählt der Zähler 25 bei jedem Taktsignal einen Wert hoch, inkrementiert diesen also.

Der sich ergebende Wert wird - bevorzugt vor oder bei dem nächsten Abgreifen der Spannung U_{HB} - über den Frequenzsignalausgang 28 dem Frequenzsignaleingang 29 der Steuerung 18 zur Verfügung gestellt und der Zähler 25 vorzugsweise zurückgesetzt. Die Steuerung 18 bestimmt aus dem übermittelten Wert eine neue Ansteuerungsfrequenz für die Schaltelemente 8 und 9 oder die Information, ob die momentane Ansteuerungsfrequenz oberhalb oder unterhalb der Resonanzfrequenz liegt. In letzterem Fall wird neue Ansteuerungsfrequenz ausgehend von der momentanen Ansteuerungsfrequenz verringert beziehungsweise vergrößert, vorzugsweise um einen vorbestimmten Wert oder um einen aus zumindest der momentanen Ansteuerungsfrequenz bestimmten Wert. Die neue Ansteuerungsfrequenz wird anstelle der bisherigen Ansteuerungsfrequenz verwendet, bis der Zähler 25 erneut einen Wert übermittelt. Auf diese Weise stellt sich die Steuerung 18 steuernd und/oder regelnd derart auf den Resonanzkreis 2 ein, dass die Ansteuerungsfrequenz sukzessive der Resonanzfrequenz des Resonanzkreises 2 angepasst wird. Auf diese Weise kann eine Angleichung der Ansteuerungsfrequenz auf die Resonanzfrequenz erfolgen, ohne dass die unmittelbare Bestimmung der Drosselspannung U_{L} und des Drosselstroms I_{L} notwendig ist. Somit kann eine kostengünstige Steuerung und/oder Regelung der Stelleinrichtung 1 erreicht werden.

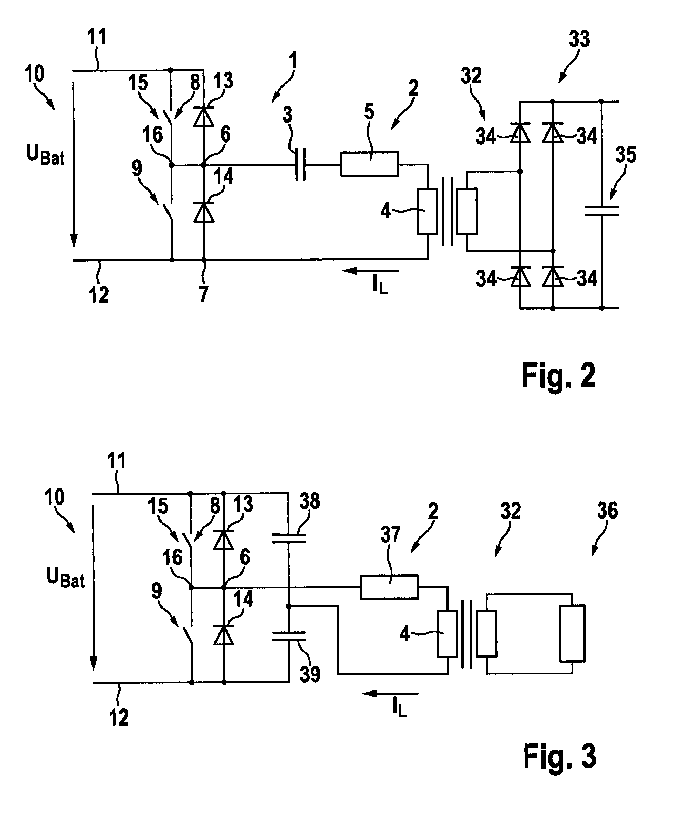

Die Figur 2 zeigt ein Schaltbild, in welchem der Einsatz der aus der Figur 1 bekannten Schaltung zur berührungslosen Energieübertragung, insbesondere für ein Aufladen einer Handwerkzeugmaschine, gezeigt ist. Dabei ist dem Resonanzkreis 2, welcher in diesem Fall beispielsweise einer Ladestation zugeordnet ist, ein weiterer Resonanzkreis 32 zugeordnet. Der weitere Resonanzkreis 32 besteht in dem hier vorliegenden Fall lediglich aus einer Spule. Der weitere Resonanzkreis 32 ist an eine Gleichrichterschaltung 33, bestehend aus vier Dioden 34 angeschlossen. Zusätzlich ist eine Glättungseinrichtung 35, insbesondere in Form eines Kondensators, vorgesehen. Das Schaltbild der Figur 2 ist vereinfacht, so ist beispielsweise die Stelleinrichtung 1 nicht vollständig dargestellt. Insofern sei für weitere Details auf die Beschreibung der Figur 1 verwiesen.

Die Figur 3 zeigt ein Schaltbild, in welchem die Verwendung der aus Figur 1 bekannten Schaltung zum Ansteuern eines Piezoschwingers 36 dargestellt ist. Wie bereits aus der Figur 2 bekannt, ist dabei dem Resonanzkreis 2 der weitere Resonanzkreis 32 zugeordnet. Dieser ist an den Piezoschwinger 36 angeschlossen. Der weitere Resonanzkreis 32 besteht auch hier lediglich aus einer Spule. Die Stelleinrichtung 1 entspricht den bereits aus den Figuren 1 und 2 bekannten Stelleinrichtungen 1. Der Aufbau des Resonanzkreises 2, welcher hier Verwendung findet, unterscheidet sich jedoch von dem anhand der Figuren 1 und 2 beschriebenen. Insofern soll im Folgenden auf die Unterschiede eingegangen werden. Der Resonanzkreis 2 weist neben der Spule 4 eine weitere Spule 37 sowie zwei Kondensatoren 38 und 39 auf. Die Spule 4 ist mit der weiteren Spule 37 in Reihe geschaltet. Die Spule 37 ist dabei mit dem Mittelabgriff 16 der Halbbrücke 15 verbunden, also zwischen den Schaltelementen 8 und 9 angeschlossen. Die Spule 4 ist auf ihrer der weiteren Spule 37 abgewandten Seite zwischen den Kondensatoren 38 und 39 angeschlossen, wobei der Kondensator 38 auf seiner der Spule 4 abgewandten Seite mit dem Pol 11 und der Kondensator 39 auf seiner der Spule 4 abgewandten Seite mit dem Pol 12 verbunden ist. Auf diese Weise ist auch hier ohne Sensorik zur Bestimmung der Drosselspannung U_{L} und des Drosselstroms I_{L} ein Betreiben des Piezoschwingers 36 möglich.

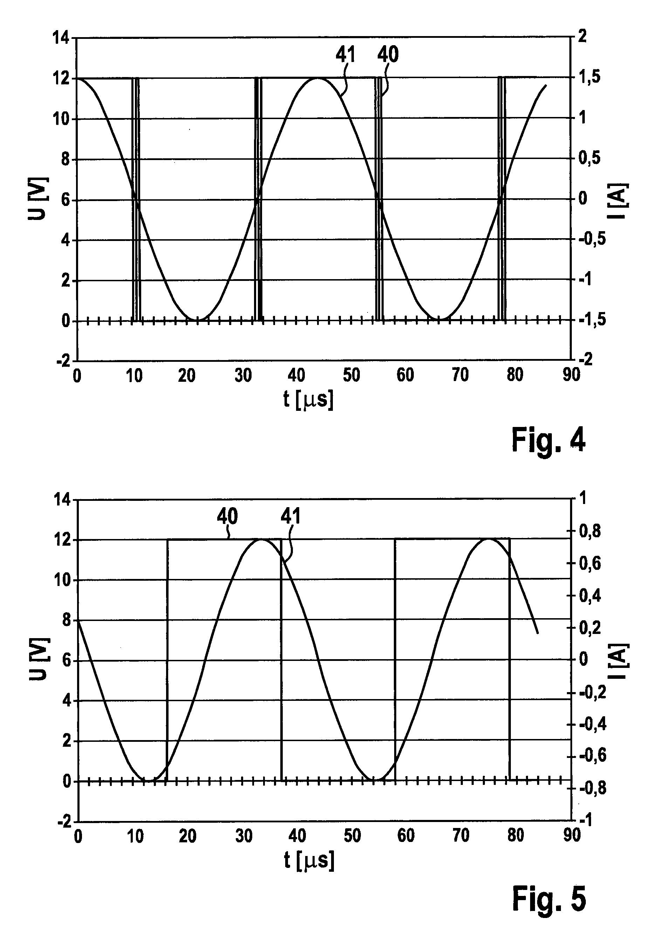

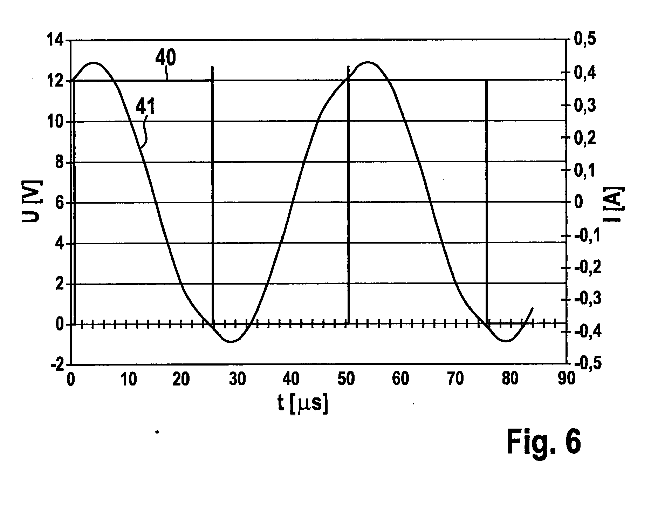

Die Figuren 4 bis 6 zeigen Diagramme, in welchen eine Spannung in Volt und ein Strom in Ampere über der Zeit in Mikrosekunden aufgetragen sind. Ein Verlauf 40 entspricht dabei der abgegriffenen Spannung U_{HB} und ein Verlauf 41 dem Drosselstrom I_{L}. Die Figur 4 zeigt den Verlauf der abgegriffenen Spannung U_{HB} und des Drosselstroms I_{L}, wenn die Ansteuerungsfrequenz der Resonanzfrequenz des Resonanzkreises 2 im Wesentlichen entspricht. Es ist erkennbar, dass die steigende beziehungsweise sinkende Flanke des Verlaufs 40 in den Wendepunkten des Verlaufs 41 liegt. Das Abgreifen der Spannung U_{HB} erfolgt in der Totzeit bei der steigenden Flanke des Verlaufs 40. Bei zu kleiner Ansteuerungsfrequenz ist der Strom hier positiv und bei zu großer negativ. Dies ist jeweils den Figuren 6 und 5 zu entnehmen. Erfolgt das Abgreifen der Spannung U_{HB} an dem Mittelabgriff 16 der Halbbrücke 15 beziehungsweise dem ersten Anschluss 6 im richtigen Zeitpunkt, so ist der Drosselstrom I_{L} gleich null. Man erhält demnach ein Digitalsignal, welches anzeigt, ob die Ansteuerungsfrequenz zu hoch oder zu niedrig ist. Mit diesem Digitalsignal kann eine Frequenznachführung mittels des Zählers 24 oder alternativ mittels eines Integrators erfolgen. Damit wird die Ansteuerungsfrequenz auf einen neuen Wert gesetzt, welcher näher an der Resonanzfrequenz liegt als der bisherige Wert oder ihr im Idealfall im Wesentlichen entspricht.

## Patentansprüche

1. Verfahren zum Betreiben einer Stelleinrichtung (1) eines Resonanzkreises (2), wobei die Stelleinrichtung (1) über mindestens zwei in Reihe geschaltete Schaltelemente (8,9) verfügt, zwischen welchen ein Anschluss (6) des Resonanzkreises (2) angeschlossen ist und die zum Erregen des Resonanzkreises (2) periodisch geöffnet und geschlossen werden, wobei sie in Abhängigkeit einer an dem Anschluss (6) abgegriffenen Spannung angesteuert werden, **dadurch gekennzeichnet, dass** die Schaltelemente (8,9) jeweils eine parallel geschaltete Freilaufdiode (13,14) aufweisen und die Spannung nur dann an dem Anschluss (6) abgegriffen wird, wenn die Schaltelemente (8,9) geöffnet sind.

2. Verfahren nach einem der vorhergehenden Ansprüche, **dadurch gekennzeichnet, dass** die abgegriffene Spannung zum Wandeln in ein Digitalsignal einem Komparator (19), insbesondere einem Schmitt-Trigger, zugeführt wird.

3. Verfahren nach Anspruch 2, **dadurch gekennzeichnet, dass** das Digitalsignal als Eingangssignal für einen Flip-Flop (20) und/oder einen Zähler (25) verwendet wird.

4. Verfahren nach Anspruch 3, **dadurch gekennzeichnet, dass** eine Steuerung (18) der-Stelleinrichtung (1) die Schaltelemente (8,9) mit einer, insbesondere mittels des Zählers (25), bestimmten Frequenz ansteuert.

5. Verfahren nach Anspruch 3, **dadurch gekennzeichnet, dass** von der Steuerung (18) dem Flip-Flop (20) und/oder dem Zähler (25) ein Taktsignal zugeführt wird.

6. Verfahren nach einem der Ansprüche 3 bis 5, **dadurch gekennzeichnet, dass** das Abgreifen der Spannung durch das dem Flip-Flop (20) zugeführte Taktsignal bewirkt wird.

7. Verfahren nach einem der vorhergehenden Ansprüche, **dadurch gekennzeichnet, dass** der Resonanzkreis (2) zur berührungslosen Energieübertragung oder zum Ansteuern eines Piezoschwingers (36) verwendet wird.

8. Stelleinrichtung (1) eines Resonanzkreises (2), insbesondere zur Durchführung des Verfahrens nach einem oder mehreren der vorhergehenden Ansprüche, mit mindestens zwei in Reihe geschalteten Schaltelementen (8,9), zwischen welchen ein Anschluss (6) des Resonanzkreises (2) angeschlossen ist und die zum Erregen des Resonanzkreises (2) periodisch geöffnet und geschlossen werden, wobei die Stelleinrichtung (1) dazu ausgebildet ist, die Schaltelemente (8,9) in Abhängigkeit einer an dem Anschluss (6) abgegriffenen Spannung anzusteuern, **dadurch gekennzeichnet, dass** die Schaltelemente (8,9) jeweils eine parallel geschaltete Freilaufdiode (13,14) aufweisen und die Spannung nur dann an dem Anschluss (6) abgegriffen wird, wenn die Schaltelemente (8,9) geöffnet sind.

## Claims

1. Method for operating an actuating device (1) of a resonant circuit (2), wherein the actuating device (1) has at least two series-connected switching elements (8, 9), between which a connection (6) of the resonant circuit (2) is connected and which are periodically opened and closed to excite the resonant circuit (2), wherein said switching elements are driven on the basis of a voltage tapped off at the connection (6), **characterized in that** the switching elements (8, 9) have in each case a parallel-connected freewheeling diode (13, 14) and the voltage is only tapped off at the connection (6) when the switching elements (8, 9) are open.

2. Method according to Claim 1, **characterized in that** the tapped-off voltage is fed to a comparator (19), in particular a Schmitt trigger, for conversion into a digital signal.

3. Method according to Claim 2, **characterized in that** the digital signal is used as input signal for a flip-flop (20) and/or a counter (25).

4. Method according to Claim 3, **characterized in that** a controller (18) of the actuating device (1) drives the switching elements (8, 9) at a frequency which is determined, in particular by means of the counter (25).

5. Method according to Claim 3, **characterized in that** a clock signal is fed from the controller (18) to the flip-flop (20) and/or to the counter (25).

6. Method according to one of Claims 3 to 5, **characterized in that** the tapping-off of the voltage is effected by means of the clock signal which is fed to the flip-flop (20).

7. Method according to one of the preceding claims, **characterized in that** the resonant circuit (2) is used for contactless energy transmission or for actuating a piezo-oscillator (36).

8. Actuating device (1) of a resonant circuit (2), in particular for implementing the method according to one or more of the preceding claims, having at least two series-connected switching elements (8, 9), between which a connection (6) of the resonant circuit (2) is connected and which are periodically opened and closed to excite the resonant circuit (2), wherein the actuating device (1) is designed to drive the switching elements (8, 9) on the basis of a voltage tapped off at the connection (6), **characterized in that** the switching elements (8, 9) each have a parallel-connected freewheeling diode (13, 14) and the voltage is only tapped off at the connection (6) when the switching elements (8, 9) are open.

## Revendications

1. Procédé pour faire fonctionner un dispositif de réglage (1) d'un circuit de résonance (2), le dispositif de réglage (1) disposant d'au moins deux éléments de commutation (8, 9) branchés en série entre lesquels est raccordée une borne (6) du circuit de résonance (2) et qui sont périodiquement ouverts et fermés pour exciter le circuit de résonance (2), ceuxci étant commandés en fonction d'une tension prélevée à la borne (6), **caractérisé en ce que** les éléments de commutation (8, 9) présentent respectivement une diode de roue libre (13, 14) branchée en parallèle et la tension n'est prélevée à la borne (6) que lorsque les éléments de commutation (8, 9) sont ouverts.

2. Procédé selon la revendication 1, **caractérisé en ce que** la tension prélevée est acheminée à un comparateur (19), notamment à un trigger de Schmitt, en vue de sa conversion en un signal numérique.

3. Procédé selon la revendication 2, **caractérisé en ce que** le signal numérique est utilisé comme signal d'entrée pour une bascule bistable (20) et/ou un compteur (25).

4. Procédé selon la revendication 3, **caractérisé en ce qu'**une commande (18) du dispositif de réglage (1) commande les éléments de commutation (8, 9) avec une fréquence définie, notamment au moyen du compteur (25).

5. Procédé selon la revendication 3, **caractérisé en ce qu'**un signal d'horloge est acheminé par la commande (18) à la bascule bistable (20) et/ou au compteur (25).

6. Procédé selon l'une des revendications 3 à 5, **caractérisé en ce que** le prélèvement de la tension est provoqué par le signal d'horloge acheminé à la bascule bistable (20).

7. Procédé selon l'une des revendications précédentes, **caractérisé en ce que** le circuit de résonance (2) est utilisé pour la transmission d'énergie sans contact ou pour la commande d'un oscillateur piézoélectrique (36).

8. Dispositif de réglage (1) d'un circuit de résonance (2), notamment pour mettre en oeuvre le procédé selon une ou plusieurs des revendications précédentes, comprenant au moins deux éléments de commutation (8, 9) branchés en série entre lesquels est raccordée une borne (6) du circuit de résonance (2) et qui sont périodiquement ouverts et fermés pour exciter le circuit de résonance (2), le dispositif de réglage (1) étant configuré pour commander les éléments de commutation (8, 9) en fonction d'une tension prélevée à la borne (6), **caractérisé en ce que** les éléments de commutation (8, 9) présentent respectivement une diode de roue libre (13, 14) branchée en parallèle et la tension n'est prélevée à la borne (6) que lorsque les éléments de commutation (8, 9) sont ouverts.
